# EUROPÄISCHE PATENTSCHRIFT

(11) **EP 3 899 558 B1**
(45) Veröffentlichungstag und Bekanntmachung des Hinweises auf die Patenterteilung: **28.08.2024**
(21) Anmeldenummer: 18830259.0
(22) Anmeldetag: 20.12.2018
(51) Int. Cl.: G01R 31/08, G01R 19/165

(54) **VERFAHREN UND PRÜFVORRICHTUNG**
METHOD AND TESTING DEVICE
PROCÉDÉ ET DISPOSITIF DE CONTRÔLE

(43) Veröffentlichungstag der Anmeldung: 27.10.2021
(73) Patentinhaber: Lisa Dräxlmaier GmbH, 84137 Vilsbiburg (DE)
(72) Erfinder: GIFTTHALER, Konrad, 84036 Hohenegglkofen (DE)
(86) Internationale Anmeldenummer: PCT/EP2018/086205
(87) Internationale Veröffentlichungsnummer: WO 2020/125996

(56) Entgegenhaltungen:
- EP-A1- 2 770 605
- WO-A1-2011/000683
- WO-A1-2016/137424
- US-A1- 2004 189 317
- US-A1- 2009 306 918
- US-A1- 2010 019 776

## Beschreibung

### Technisches Gebiet

Die vorliegende Erfindung betrifft ein Verfahren zum Prüfen eines Kabelsatzes mit einer Anzahl von netzwerken für ein Bordnetz eines Fahrzeugs. Ferner betrifft die vorliegende Erfindung eine entsprechende Prüfvorrichtung.

### Stand der Technik

Die vorliegende Erfindung wird im Folgenden in Verbindung mit Bordnetzen von Fahrzeugen beschrieben.

In modernen Fahrzeugen wird eine Vielzahl elektrischer und elektronischer Komponenten verbaut. Solche Komponenten können z.B. Steuergeräte sein, die Komfortfunktionen bzw. Fahrerassistenzfunktionen bereitstellen. In einem modernen Fahrzeug kann eine Vielzahl solcher Steuergeräte verbaut sein. Üblicherweise werden die Steuergeräte über einen Kabelbaum bzw. Kabelsatz elektrisch miteinander verbunden. Ein solcher Kabelbaum bzw. Kabelsatz kann dabei unterschiedliche elektrische Netzwerke aufweisen.

Zur Steigerung der Effizienz bei der Fahrzeugmontage werden zukünftig elektrische Komponenten in den Kabelbaum bzw. Kabelsatz verlagert. Beispielsweise können Schaltelemente, Verteiler, Schutzdioden und kleine Steuergeräte, z.B. für eine Innenraumbeleuchtung, in den Kabelbaum bzw. Kabelsatz integriert werden. Solche Komponenten werden also bereits bei der Herstellung bzw. Produktion des Kabelbaums bzw. Kabelsatzes in diesen integriert und dem Fahrzeughersteller geliefert.

Der bisher passive Kabelbaum bzw. Kabelsatz wandelt sich dadurch zunehmend zu einem komplexen Gebilde mit mehreren elektrischen Netzwerken und aktiven elektrischen Komponenten. Die US 2010 / 00 19 776 A1 offenbart ein Verfahren zur Analyse eines supraleitenden Drahts. Aus WO 2011/000683 A1 ist ein Verfahren zur Prüfung eines einzelnen Landverbindungskabels zwischen einem Schiffsbordnetz und eines landseitigen Energieversorgungsnetzes bekannt.

Auf Grund der gestiegenen Komplexität des Kabelbaums bzw. Kabelsatzes steigt auch der Aufwand für eine Prüfung des Kabelbaums bzw. Kabelsatzes nach der Produktion.

### Beschreibung der Erfindung

Eine Aufgabe der Erfindung ist es daher, unter Einsatz konstruktiv möglichst einfacher Mittel eine Prüfung komplexer Kabelbäume zu ermöglichen.

Die Aufgabe wird durch die Gegenstände der unabhängigen Ansprüche gelöst. Vorteilhafte Weiterbildungen der Erfindung sind in den abhängigen Ansprüchen, der Beschreibung und den begleitenden Figuren angegeben. Insbesondere können die unabhängigen Ansprüche einer Anspruchskategorie auch analog zu den abhängigen Ansprüchen einer anderen Anspruchskategorie weitergebildet sein.

Ein erfindungsgemäßes Verfahren zum Prüfen eines Kabelsatzes mit einer Anzahl, also mit einem oder mehreren Netzwerken, wobei mindestens eines der Netzwerke eine Anzahl, also eine oder mehrere elektrische Baugruppen aufweist, weist die folgenden Schritte auf: Beaufschlagen der Netzwerke, insbesondere derer, welche elektrische Baugruppen aufweisen, mit einem Wechselspannungssignal, Messen des Stroms und der Spannung für jedes, bzw. in jedem, der mit dem Wechselspannungssignal beaufschlagten Netzwerke, Vergleichen von basierend auf dem jeweils gemessen Strom und der jeweils gemessenen Spannung erstellten Spannungs-Strom-Kennlinien der jeweiligen Netzwerke mit einer vorgegebenen Soll-Spannungs-Strom-Kennlinie für das jeweilige Netzwerk, und Ausgeben einer Fehlermeldung, wenn eine der basierend auf dem jeweils gemessen Strom und der jeweils gemessenen Spannung erstellten Spannungs-Strom-Kennlinien von der entsprechenden Soll-Spannungs-Strom-Kennlinie um mehr als einen vorgegebenen Schwellwert abweicht.

Ein erfindungsgemäße Prüfvorrichtung zur Prüfung eines Kabelsatzes mit einer Anzahl, also mit einem oder mehreren Netzwerken, wobei mindestens eines der Netzwerke eine Anzahl, also eine oder mehrere elektrische Baugruppen aufweist, weist auf: eine Signalquelle, welche ausgebildet ist, ein Wechselspannungssignal zu erzeugen, eine steuerbare Koppeleinrichtung, welche ausgebildet ist, die Netzwerke, insbesondere jene, welche elektrische Baugruppen aufweisen, gesteuert mit der Signalquelle zu koppeln, eine Messeinrichtung, welche ausgebildet ist, den Strom und die Spannung für jedes, bzw. in jedem, der mit der Signalquelle gekoppelten Netzwerke zu messen, und eine Steuereinrichtung, welche ausgebildet ist, basierend auf dem jeweils gemessenen Strom und der jeweils gemessenen Spannung entsprechende Spannungs-Strom-Kennlinien der jeweiligen Netzwerke zu erstellen und die erstellten Spannungs-Strom-Kennlinien mit vorgegebenen Soll-Spannungs-Strom-Kennlinien zu vergleichen, wobei die Steuereinrichtung ferner ausgebildet ist, eine Fehlermeldung auszugeben, wenn eine der erstellten Spannungs-Strom-Kennlinien von der entsprechenden Soll-Spannungs-Strom-Kennlinie um mehr als einen vorgegebenen Schwellwert abweicht.

Die vorliegende Erfindung basiert auf der Erkenntnis, dass ein Kabelsatz mit elektrischen Komponenten nur schwer mathematisch abgebildet werden kann. Bei der Verwendung einer RLC-Messmethode kann die verbaute Elektronik mit komplexen Impedanzen folglich schnell zu einer nicht mehr (in angemessener Zeit) lösbaren Aufgabe führen. Die Kombinatorik der möglichen Bauteile wie Widerstände, Kondensatoren und Induktivitäten mit Halbleitern in Parallel- bzw. Serienschaltung würde eine absolute Messung mit anschließender mathematischer Auflösung nahezu unmöglich machen. Es versteht sich, dass der Begriff **"elektrische Komponente" in Bezug auf den Kabelsatz auch elektronische Komponenten** bzw. eine Kombination aus elektrischen und elektronischen Komponenten umfassen kann. Die vorliegende Erfindung sieht folglich eine andere Art der Prüfung elektrischer Netzwerke eines Kabelsatzes vor, bei welcher keine komplexe mathematische Berechnung durchgeführt werden muss. Insbesondere nutzt die vorliegende Erfindung die Erkenntnis, dass sich die Signaturen mehrerer miteinander verschalteter Bauteile, wie z.B. Dioden, Kondensatoren, Widerständen und Induktivitäten und elektronischer Komponenten, überlagern.

Der Kabelsatz kann weiterhin auch Stromschienen aufweisen. Unter einer elektrischen Baugruppe oder elektrischen Komponente können auch Schalter, Schütze oder Relais verstanden werden.

Die vorliegende Erfindung sieht daher vor, dass Signaturen, also U/I-Kennlinien oder Spannungs-Strom-Kennlinien, für die Netzwerke des Kabelsatzes aufgenommen und analysiert werden. Dazu erzeugt eine Signalquelle ein Wechselspannungssignal, welches als Testsignal für die einzelnen Netzwerke dient. Um die Spannungs-Strom-Kennlinien aufzunehmen, werden die Netzwerke mit den erzeugten Wechselspannungssignalen beaufschlagt.

Die Kabelsätze weisen üblicherweise eine Vielzahl von Steckern auf, über welche die einzelnen Netzwerke kontaktiert werden können. Die Informationen über die vorhandenen Netzwerke und deren Anschlüsse, also z.B. Steckerpins, sind für einen Kabelsatz bekannt, da er nach klar definierten Vorgaben hergestellt wird. Folglich können diese Informationen für die Prüfung z.B. aus einer entsprechenden Datenbank abgerufen werden. Die steuerbare Koppeleinrichtung kann folglich die jeweils benötigten Pins in den entsprechenden Steckern kontaktieren, um ein Netzwerk mit der Signalquelle zu koppeln. Beispielsweise kann die Koppeleinrichtung durch die Steuereinrichtung der Prüfvorrichtung gesteuert werden. In der Steuereinrichtung können dazu die benötigten Informationen über den Kabelsatz hinterlegt sein. Alternativ kann die Steuereinrichtung mit einem Server verbunden werden, der diese Informationen zur Verfügung stellt.

Während der Beaufschlagung der einzelnen Netzwerke mit dem Wechselspannungssignal werden die Strom- und Spannungsverläufe in den Netzwerken gemessen. Dazu kann die Messeinrichtung z.B. zwischen der Koppeleinrichtung und der Signalquelle angeordnet werden oder in der Koppeleinrichtung angeordnet sein bzw. mit entsprechenden Anschlüssen in der Koppeleinrichtung verbunden sein.

Aus den gemessenen Strom- und Spannungsverläufen kann die Steuereinrichtung entsprechende Spannungs-Strom-Kennlinien erstellen. Die Spannungs-Strom-Kennlinien können z.B. als zweidimensionale Datenstrukturen bzw. Graphen dargestellt werden, bei welchen eine Achse den Strom und eine Achse die Spannung kennzeichnet.

Da die Eigenschaften der Netzwerke im fehlerfreien Zustand bekannt sind, können für die einzelnen Netzwerke jeweils Soll-Spannungs-Strom-Kennlinien vorgegeben bzw. gemessen werden.

Durch einen Vergleich der Soll-Spannungs-Strom-Kennlinien mit den basierend auf dem jeweils gemessenen Strom und der jeweils gemessenen Spannung erstellten Spannungs-Strom-Kennlinien der einzelnen Netzwerke kann daraufhin festgestellt werden, ob das jeweilige Netzwerk dem Soll-Zustand entspricht. Wäre in dem Netzwerk z.B. ein Kurzschluss vorhanden oder wäre ein Kondensator durchlegiert oder würde ein anderer Fehler bestehen, würde sich die entsprechende Signatur bzw. Spannungs-Strom-Kennlinie verändern und der Fehler würde sofort detektiert.

Der vorgegebene Schwellwert kann z.B. einen Abstand zwischen der gemessenen Spannungs-Strom-Kennlinie und der Soll-Spannungs-Strom-Kennlinie kennzeichnen, der nicht überschritten werden darf. Der Schwellwert kann dazu z.B. experimentell bestimmt werden oder mathematisch definiert werden. Beispielsweise kann eine maximale Abweichung für die Stromachse und eine maximale Abweichung für die Spannungsachse vorgegeben werden. Dabei können die maximale Abweichung für die Stromachse und die maximale Abweichung für die Spannungsachse voneinander verschieden sein.

Der Vergleich zwischen der gemessenen Spannungs-Strom-Kennlinie und der Soll-Spannungs-Strom-Kennlinie kann z.B. optisch auf einem Bildschirm durch einen Benutzer durchgeführt werden. Alternativ kann der Vergleich z.B. auch mathematisch durch eine Steuereinheit z.B. einer Prüfanlage durchgeführt werden.

Mit Hilfe der vorliegenden Erfindung kann ein Kabelsatz sehr effizient und einfach geprüft werden. Insbesondere reduziert sich die zur Prüfung benötigte Zeit. Ferner wird der Einsatz von komplexen und damit teuren Mess-/Prüfmitteln reduziert. Schließlich kann mit der vorliegenden Erfindung auch die Schädigung von Elektronik-Bauteilen erkannt werden, welche im Bordnetz verbaut sind. Ist z.B. eine ESD-Schutzdiode beschädigt, wirkt sich dies sofort auf die Spannungs-Strom-Kennlinien aus und der Fehler kann erkannt werden. Dies ist mit herkömmlichen Prüfverfahren nicht ohne weiteres möglich.

Weitere Ausführungsformen und Weiterbildungen ergeben sich aus den Unteransprüchen sowie aus der Beschreibung unter Bezugnahme auf die Figuren.

In einer Ausführungsform weist das Verfahren das Erfassen der Soll-Spannungs-Strom-Kennlinien anhand eines vorgegebenen Kabelsatzes auf. In der Prüfvorrichtung kann die Steuereinrichtung ausgebildet sein, die Soll-Spannungs-Strom-Kennlinien anhand eines vorgegebenen Kabelsatzes zu erfassen.

Die Soll-Spannungs-Strom-**Kennlinie kann z.B. anhand eines sog. "Golden Samples",** also eines garantiert fehlerfreien Referenz-Kabelsatzes, erstellt bzw. aufgenommen werden. Dazu kann die Steuereinrichtung z.B. in einen vorgegebenen Betriebsmodus versetzt werden, in welchem sie - wie oben beschrieben - eine Spannungs-Strom-Kennlinie aufnimmt und diese dann als die jeweilige Soll-Spannungs-Strom-Kennlinie speichert.

Es versteht sich, dass die Soll-Spannungs-Strom-Kennlinie z.B. auch mathematisch bestimmt werden kann. Die erwartete Soll-Spannungs-Strom-Kennlinie kann z.B. basierend auf einem Schaltplan des jeweiligen Netzwerks berechnet werden. Die Berechnung der Soll-Spannungs-Strom-Kennlinie kann z.B. in einer externen Recheneinrichtung, also z.B. einem Server, erfolgen. Von diesem kann die Soll-Spannungs-Strom-Kennlinie an die Steuereinheit übermittelt werden.

Es versteht sich, dass die Soll-Spannungs-Strom-Kennlinie vor der eigentlichen Messung erfasst bzw. bestimmt werden kann. Die Soll-Spannungs-Strom-Kennlinie kann z.B. in der Steuereinrichtung gespeichert und bei Bedarf abgerufen werden.

In einer weiteren Ausführungsform kann das Verfahren das sequentielle elektrische Verbinden der Netzwerke mit einer Signalquelle des Wechselspannungssignals aufweisen. Der Schritt des Messens kann dabei für das jeweils kontaktierte Netzwerk durchgeführt werden. In der Prüfvorrichtung kann die Steuereinrichtung ausgebildet sein, die steuerbare Koppeleinrichtung derart anzusteuern, dass diese die Netzwerke sequentiell mit der Signalquelle koppelt. Ferner kann die Messeinrichtung ausgebildet sein, für das jeweils kontaktierte Netzwerk den Strom und die Spannung zu messen.

Die einzelnen Netzwerke können sequentiell mit der Signalquelle gekoppelt werden. Das heißt, es wird immer nur eines der Netzwerke in dem Kabelsatz vermessen. Die Prüfvorrichtung kann folglich sehr einfach gehalten werden. Beispielsweise ist nur eine Signalquelle nötig und die Messeinrichtung muss jeweils nur einen Strom und eine Spannung erfassen.

In noch einer Ausführungsform kann das Verfahren das gleichzeitige elektrische Verbinden von mindestens zwei der Netzwerke mit einer Signalquelle des Wechselspannungssignals aufweisen. Der Schritt des Messens kann für die jeweils kontaktierten Netzwerke durchgeführt werden. In der Prüfvorrichtung kann die Steuereinrichtung ausgebildet sein, die steuerbare Koppeleinrichtung derart anzusteuern, dass diese mindestens zwei der Netzwerke gleichzeitig mit der Signalquelle koppelt. Ferner kann die Messeinrichtung ausgebildet sein, für die jeweils kontaktierten Netzwerke den Strom und die Spannung zu messen.

Da Kabelbäume eine Vielzahl von Netzwerken aufweisen, kann es wünschenswert sein, die Prüfung der einzelnen Netzwerke zu parallelisieren. Dazu können mehrere der Netzwerke gleichzeitig mit der Signalquelle gekoppelt werden. Beispielsweise können mehre der Netzwerke parallel mit der Signalquelle verbunden werden. Alternativ kann die Signalquelle mehrere Signalerzeuger aufweisen, die für jedes der Netzwerke ein eigenes Wechselspannungssignal erzeugen. Zusätzlich kann die Messeinrichtung für jedes der Netzwerke einen separaten Spannungs- und Stromsensor aufweisen.

In einer weiteren Ausführungsform kann das Verfahren das Erzeugen des Wechselspannungssignals mit einer vorgegebenen Frequenz und Amplitude aufweisen. Das Wechselspannungssignal kann insbesondere in Abhängigkeit der Eigenschaften, also z.B. der Impedanz, des zu vermessenden Netzwerks erzeugt werden. In der Prüfvorrichtung kann die Signalquelle ausgebildet sein, das Wechselspannungssignal mit einer vorgegebenen Frequenz und Amplitude zu erzeugen. Die Signalquelle kann insbesondere ausgebildet sein, das Wechselspannungssignal in Abhängigkeit der Eigenschaften, also z.B. der Impedanz, des zu vermessenden Netzwerks zu erzeugen.

Die einzelnen Netzwerke in dem Kabelsatz können unterschiedliche Elemente aufweisen und damit auch unterschiedliche Impedanzen. Beispielsweise können Netzwerke lediglich der Verbindung mehrere Stecker dienen, also lediglich Leitungen aufweisen. Andere Netzwerke können aktive Komponenten, wie z.B. LIN-Bus-fähige LED-Steuergräte aufweisen. Wieder andere Netzwerke können z.B. elektrische Verteiler aufweisen, in welchen z.B. Dioden und elektronische Schaltelemente angeordnet sein können.

Auf Grund der unterschiedlichen Ausgestaltungen der einzelnen Netzwerke kann es vorteilhaft sein, das Wechselspannungssignal z.B. mit unterschiedlichen Amplituden und Frequenzen zu erzeugen, die dem jeweiligen Netzwerk angepasst sind. Beispielsweise kann die Amplitude erhöht werden, wenn die ohmsche Last in einem Netzwerk hoch ist. Die Frequenz kann z.B. derart angepasst werden, dass sich für das jeweilige Netzwerk ein großer Ausschlag bzw. eine große Signalspanne bei der Strom- und Spannungsmessung ergibt.

In einer weiteren Ausführungsform kann die Koppeleinrichtung eine mechanische Verbindungseinheit aufweisen, welche ausgebildet ist, alle Stecker des Kabelsatzes elektrisch zu kontaktieren.

Die Verbindungseinheit kann eine Art Adapter sein, welcher dazu dient, die einzelnen Stecker des Kabelsatzes elektrisch zu kontaktieren. Dazu kann die Verbindungseinheit z.B. für jeden Stecker des Kabelsatzes das entsprechende Gegenstück aufweisen. Es versteht sich, dass die Stecker des Kabelsatzes z.B. manuell in die entsprechenden Gegenstücke gesteckt werden können. Bei einer automatisierten Herstellung des Kabelsatzes kann der Produktionsautomat die Stecker in die entsprechenden Gegenstücke stecken. Mit der Verbindungseinheit kann der gesamte Kabelsatz, also alle zu prüfenden Netzwerke, sehr einfach kontaktiert werden.

Die Verbindungseinheit kann die einzelnen Pins der Stecker des Kabelsatzes z.B. an entsprechende Anschlüsse leiten bzw. mit diesen verbinden. An den Anschlüssen können die Pins für die Messung und Einspeisung des Wechselspannungssignals elektrisch kontaktiert werden.

In noch einer Ausführungsform kann die Koppeleinrichtung eine Adaptionseinrichtung aufweisen, welche ausgebildet ist, gesteuert einzelne Netzwerke mit der Signalquelle und/oder der Messeinrichtung zu koppeln.

Die Adaptionseinrichtung kann ein Netzwerk aus Schaltelementen bzw. eine Schaltermatrix aufweisen, welche es ermöglicht, einzelne Pins der Stecker des Kabelsatzes flexibel mit der Signalquelle und/oder der Messeinrichtung zu koppeln.

Beispielsweise kann die Signalquelle an zwei Stellen mit einem Netzwerk gekoppelt sein. Ein Stromsensor kann in dem Strompfad zwischen Signalquelle und Netzwerk angeordnet sein. Ferner kann ein Spannungssensor parallel zu dem Netzwerk angeordnet sein. Wird eine Adaptionseinrichtung verwendet, kann diese zwischen dem Stromsensor und dem Kabelsatz angeordnet sein. Der Spannungssensor kann die Spannung über die Adaptionseinrichtung messen, also über die Adaptionseinrichtung parallel zu dem jeweiligen Netzwerk geschaltet werden.

Es versteht sich, dass die Adaptionseinrichtung auch in Verbindung mit der Verbindungseinheit genutzt werden kann. In solch einer Ausführung kann die Verbindungseinheit zwischen Adaptionseinrichtung und Kabelsatz angeordnet sein.

Es versteht sich, dass die Steuereinrichtung in datenkommunikativer Verbindung mit der Adaptionseinrichtung gekoppelt sein kann, um die Adaptionseinrichtung anzusteuern und die entsprechenden elektrischen Verbindungen einzustellen.

### Kurze Figurenbeschreibung

Nachfolgend werden vorteilhafte Ausführungsbeispiele der Erfindung unter Bezugnahme auf die begleitenden Figuren erläutert. Es zeigen:
- Figur 1: ein Ablaufdiagramm eines Ausführungsbeispiels eines Verfahrens gemäß der vorliegenden Erfindung;
- Figur 2: ein Blockschaltbild eines Ausführungsbeispiels einer Prüfvorrichtung gemäß der vorliegenden Erfindung; und
- Figur 3: ein Blockschaltbild eines weiteren Ausführungsbeispiels einer Prüfvorrichtung gemäß der vorliegenden Erfindung.

Die Figuren sind lediglich schematische Darstellungen und dienen nur der Erläuterung der Erfindung. Gleiche oder gleichwirkende Elemente sind durchgängig mit den gleichen Bezugszeichen versehen.

### Detaillierte Beschreibung

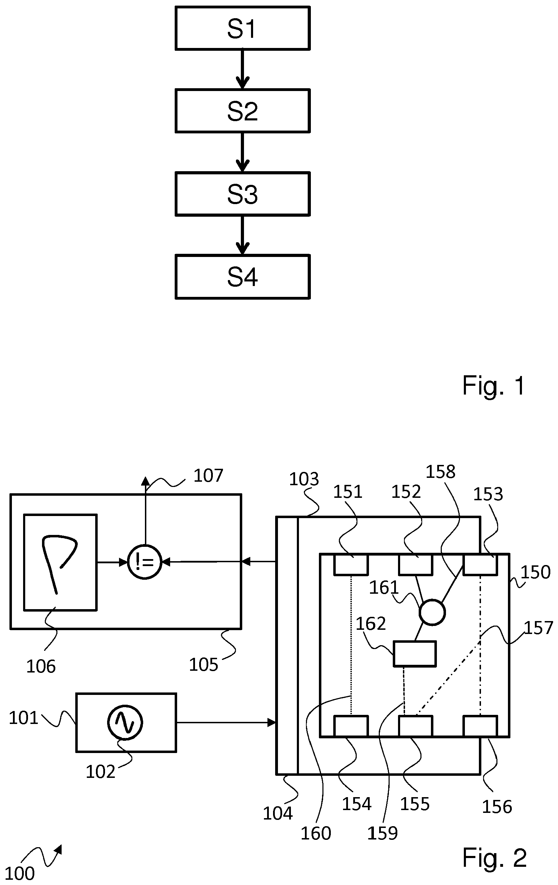

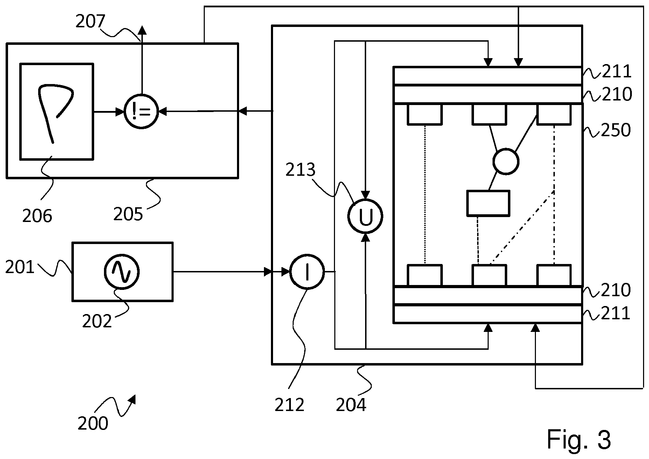

Zum leichteren Verständnis werden in der folgenden Beschreibung der verfahrensbezogenen Figur 1 die Bezugszeichen zu den Figuren 2 und 3 als Referenz beibehalten. Figur 1 zeigt ein Ablaufdiagramm eines Ausführungsbeispiels eines Verfahrens zum Prüfen eines Kabelsatzes 150, 250 mit einer Anzahl von Netzwerken 157, 158, 159, 160, wobei mindestens eines der Netzwerke 157, 158, 159, 160 eine Anzahl elektrischer Baugruppen 161, 162 aufweist.

In einem ersten Schritt S1 des Beaufschlagens werden die Netzwerke 157, 158, 159, 160 mit einem Wechselspannungssignal 102, 202 beaufschlagt. In einem zweiten Schritt S2 des Messens werden der Strom und die Spannung für jedes der mit dem Wechselspannungssignal 102, 202 beaufschlagten Netzwerke 157, 158, 159, 160 gemessen. In einem dritten Schritt S3 des Vergleichens werden basierend auf dem jeweils gemessen Strom und der jeweils gemessenen Spannung erstellte Spannungs-Strom-Kennlinien der jeweiligen Netzwerke 157, 158, 159, 160 mit einer vorgegebenen Soll-Spannungs-Strom-Kennlinie für das jeweilige Netzwerk 157, 158, 159, 160 verglichen. In einem vierten Schritt des Ausgebens wird eine Fehlermeldung 107, 207 ausgegeben, wenn eine der basierend auf dem jeweils gemessen Strom und der jeweils gemessenen Spannung erstellten Spannungs-Strom-Kennlinien von der entsprechenden Soll-Spannungs-Strom-Kennlinie um mehr als einen vorgegebenen Schwellwert abweicht. Es versteht sich, dass das Warnsignal auch einen Hinweis darauf geben kann, bei welchem der Netzwerke die Abweichung aufgetreten ist, sodass eine Reparatur des entsprechenden Netzwerks möglich ist.

Beim Beaufschlagen der Netzwerke 157, 158, 159, 160 können die Netzwerke 157, 158, 159, 160 sequentiell elektrisch mit einer Signalquelle 101, 201 für das Wechselspannungssignal 102, 202 verbunden werden. Das Messen wird entsprechend für das jeweils kontaktierte Netzwerk 157, 158, 159, 160 durchgeführt. Alternativ können mindestens zwei der Netzwerke 157, 158, 159, 160 gleichzeitig elektrisch mit der Signalquelle 101, 201 des Wechselspannungssignals 102, 202 verbunden werden. Das Messen wird dabei für die jeweils kontaktierten Netzwerke 157, 158, 159, 160 durchgeführt.

Die Soll-Spannungs-Strom-Kennlinie 106, 206 kann für jedes der Netzwerke 157, 158, 159, 160 anhand eines vorgegebenen Kabelsatzes 150, 250, z.B. eines sog. "Golden Samples" durchgeführt werden. Dadurch wird sichergestellt, dass eine aufgenommene Soll-Spannungs-Strom-Kennlinie 106, 206 korrekt ist.

Das Wechselspannungssignal 102, 202 kann z.B. mit einer vorgegebenen Frequenz und Amplitude erzeugt werden. Die Frequenz und die Amplitude können z.B. in Abhängigkeit der Eigenschaften des zu vermessenden Netzwerks 157, 158, 159, 160 erzeugt werden.

Figur 2 zeigt ein Blockschaltbild einer Prüfvorrichtung 100. Die Prüfvorrichtung 100 dient der Prüfung eines Kabelsatzes 150 mit einer Anzahl von Netzwerken 157, 158, 159, 160 und einer Anzahl elektrischer Baugruppen 161, 162. Der Kabelsatz weist vier Netzwerke 157 (Strichpunktlinie), 158 (durchgezogene Linie), 159 (gestrichelte Linie), 160 (gepunktete Linie) auf. In dem Netzwerk 158 ist ferner eine als Verteiler 161 ausgebildete elektrische Baugruppe angeordnet. Zwischen den Netzwerken 158 und 159 ist ferner eine als Steuergerät 162 ausgebildete elektrische Baugruppe angeordnet. Der Verteiler 161 und das Steuergerät 162 können z.B. Dioden, Kapazitäten, Induktivitäten, Widerstände, Halbleiterschalter und dergleichen aufweisen. Das Kabelsatz 150 weist ferner sechs Stecker 151, 152, 153, 154, 155, 156 auf, welche die dazu dienen, die Netzwerke 157, 158, 159, 160 zu kontaktieren.

Die Prüfvorrichtung 100 weist eine Signalquelle 101 auf, die mit einer steuerbaren Koppeleinrichtung 103 verbunden ist. Eine Messeinrichtung 104 ist zwischen der Signalquelle 101 und der steuerbaren Koppeleinrichtung 103 angeordnet. Ferner ist eine Steuereinrichtung 105 mit der Messeinrichtung 104 verbunden.

Die Signalquelle 101 erzeugt ein Wechselspannungssignal 102 und stellt dieses der steuerbaren Koppeleinrichtung 103 bereit. Die steuerbare Koppeleinrichtung 103 kann die einzelnen Netzwerke 157, 158, 159, 160 des Kabelsatzes 150 gesteuert mit der Signalquelle 101 koppeln. Das bedeutet, dass die steuerbare Koppeleinrichtung 103 die entsprechenden Pins in den Steckern 151, 152, 153, 154, 155, 156 kontaktiert, wenn eines der Netzwerke 157, 158, 159, 160 mit dem Wechselspannungssignal 102 beaufschlagt werden soll.

Die Messeinrichtung 104 ist derart zwischen der Signalquelle 101 und dem Kabelsatz 150 bzw. der steuerbaren Koppeleinrichtung 103 angeordnet, dass sie sowohl den Strom durch als auch die Spannung über das jeweilige Netzwerk 157, 158, 159, 160 erfassen kann. Die Messeinrichtung 104 stellt die gemessenen Werte für Strom und Spannung der Steuereinrichtung 105 bereit. Die Steuereinrichtung 105 erstellt basierend auf dem jeweils gemessenen Strom und der jeweils gemessenen Spannung entsprechende Spannungs-Strom-Kennlinien für die jeweiligen Netzwerke 157, 158, 159, 160. Diese Spannungs-Strom-Kennlinien vergleicht die Steuereinrichtung 105 mit vorgegebenen Soll-Spannungs-Strom-Kennlinien 106 und gibt eine Fehlermeldung 107 aus, wenn eine der erstellten Spannungs-Strom-Kennlinien von der entsprechenden Soll-Spannungs-Strom-Kennlinie 106 um mehr als einen vorgegebenen Schwellwert abweicht.

Figur 3 zeigt ein Blockschaltbild einer weiteren Prüfvorrichtung 200. Die einzelnen Elemente des Kabelsatzes 250 sind in Fig. 3 der Übersichtlichkeit halber nicht separat mit Bezugszeichen versehen. Die Prüfvorrichtung 200 basiert auf der Prüfvorrichtung 100. Folglich weist die Prüfvorrichtung 200 eine Signalquelle 201 auf, die mit einer steuerbaren Koppeleinrichtung verbunden ist. Eine Messeinrichtung 204 ist zwischen der Signalquelle 201 und der steuerbaren Koppeleinrichtung angeordnet. Ferner ist eine Steuereinrichtung 205 mit der Messeinrichtung 204 verbunden.

Die steuerbare Koppeleinrichtung der Prüfvorrichtung 200 ist nicht separat mit einem Bezugszeichen versehen und weist eine mechanische Verbindungseinheit 210 und eine Adaptionseinrichtung 211 auf.

Die mechanische Verbindungseinheit 210 dient dazu, alle Stecker des Kabelsatzes 250 elektrisch zu kontaktieren. Dazu kann die mechanische Verbindungseinheit 210 z.B. Gegenstücke zu den Steckern des Kabelsatzes aufweisen. Alternativ kann die mechanische Verbindungseinheit 210 auch entsprechende Prüfkontakte oder Kontaktstifte aufweisen, um die Pins in den Steckern zu kontaktieren. Die mechanische Verbindungseinheit 210 kann ihrerseits Kontakt aufweisen, welche dazu dienen die mechanische Verbindungseinheit 210 elektrisch zu kontaktieren. Diese Kontakte können folglich intern in der mechanischen Verbindungseinheit 210 elektrisch mit den Aufnahmen für die Stecker des Kabelsatzes verbinden sein.

Die Adaptionseinrichtung 211 dient dazu gesteuert einzelne Netzwerke mit der Signalquelle 201 und der Messeinrichtung 204 zu koppeln. Die Adaptionseinrichtung 211 ist dazu mit der mechanischen Verbindungseinheit 210 verbunden, kann über diese also alle Netzwerke bzw. Pins der Stecker des Kabelsatzes 250 kontaktieren. Ferner ist die Adaptionseinrichtung 211 mit der Messeinrichtung 204 gekoppelt, so dass die Messeinrichtung 204 über die Adaptionseinrichtung 211 in den entsprechenden Netzwerken den Strom und die Spannung messen kann. Dazu kann die Adaptionseinrichtung 211 z.B. eine Schaltmatrix aufweisen, welche die Kontakte der Adaptionseinrichtung 211 zur Signalquelle 201 und der Messeinrichtung 204 flexibel mit unterschiedlichen Kontakten der mechanischen Verbindungseinheit 210 koppeln kann. Bei der Prüfvorrichtung 200 ist die Steuereinrichtung 205 mit der Adaptionseinrichtung 211 gekoppelt, um diese entsprechend der aktuellen Messaufgabe anzusteuern. Es versteht sich, dass alternativ auch eine separate Steuerung für die Adaptionseinrichtung 211 vorgesehen sein kann.

Die Messeinrichtung 204 weist einen Stromsensor 212 auf, der in dem Strompfad von der Signalquelle 201 zur Adaptionseinrichtung 211 angeordnet ist. Ferner weist die Messeinrichtung 204 einen Spannungssensor 213 auf, der die Spannung über dem jeweiligen Netzwerk misst.

Der Stromsensor 212 und der Spannungssensor 213 sind mit der Steuereinrichtung 205 gekoppelt. Beispielsweise können die Sensoren 212, 213 analoge Signale ausgeben. Entsprechend kann die Steuereinrichtung 205 Analog-Digital-Wandler aufweisen, um die Signale auszuwerten. Es versteht sich, dass andere Arten von Schnittstellen, z.B. digitale Schnittstellen ebenfalls möglich sind.

Die Steuereinrichtung 205 erstellt, wie oben bereits erwähnt, basierend auf den gemessenen Strom- und Spannungswerten eine Signatur bzw. eine Spannungs-Strom-Kennlinie und vergleicht diese mit einer Soll-Spannungs-Strom-Kennlinie 206 für das jeweilige Netzwerk. Wenn die Spannungs-Strom-Kennlinie für eines der Netzwerke um mehr als einen vorgegebenen Schwellwert von der entsprechenden Soll-Spannungs-Strom-Kennlinie abweicht, gibt die Steuereinrichtung 205 eine entsprechende Warnmeldung 207 aus.

Da es sich bei den vorhergehend detailliert beschriebenen Vorrichtungen und Verfahren um Ausführungsbeispiele handelt, können sie in üblicher Weise vom Fachmann in einem weiten Umfang modifiziert werden, ohne den Bereich der Erfindung, die in den Ansprüchen definiert ist, zu verlassen. Insbesondere sind die mechanischen Anordnungen und die Größenverhältnisse der einzelnen Elemente zueinander lediglich beispielhaft. Es versteht sich, dass die Begriffe Kabelbaum, Kabelsatz, Bordnetz, Verkabelung und dergleichen austauschbar sind und sich auf den gleichen Gegenstand beziehen können. Gleiches gilt für die Begriffe elektrische Baugruppen, elektronische Baugruppen und Baugruppen.

### BEZUGSZEICHENLISTE

- 100, 200: Prüfvorrichtung
- 101, 201: Signalquelle
- 102, 202: Wechselspannungssignal
- 103: Koppeleinrichtung
- 104,204: Messeinrichtung
- 105, 205: Steuereinrichtung
- 106,206: Soll-Spannungs-Strom-Kennlinien
- 107,207: Fehlermeldung

- 210: Verbindungseinheit
- 211: Adaptionseinrichtung
- 212: Stromsensor
- 213: Spannungssensor

- 150, 250: Kabelsatz
- 151, 152, 153, 154, 155, 156: Stecker
- 157, 158, 159, 160: Netzwerk
- 161, 162: elektrische Baugruppe

- S1, S2, S3, S4: Verfahrensschritt

## Patentansprüche

1. Verfahren zum Prüfen eines Kabelsatzes (150, 250) mit einer Anzahl von Netzwerken (157, 158, 159, 160) für ein Bordnetz eines Fahrzeugs, wobei mindestens eines der Netzwerke (157, 158, 159, 160) eine Anzahl elektrischer Baugruppen (161, 162) aufweist, aufweisend die Schritte:
Beaufschlagen (S1) der Netzwerke (157, 158, 159, 160) mit einem Wechselspannungssignal (102, 202),
Messen (S2) des Stroms und der Spannung für jedes der mit dem Wechselspannungssignal (102, 202) beaufschlagten Netzwerke (157, 158, 159, 160),
Vergleichen (S3) von basierend auf dem jeweils gemessenen Strom und der jeweils gemessenen Spannung erstellten Spannungs-Strom-Kennlinien der jeweiligen Netzwerke (157, 158, 159, 160) mit einer vorgegebenen Soll-Spannungs-Strom-Kennlinie (106, 206) für das jeweilige Netzwerk (157, 158, 159, 160), und
Ausgeben (S4) einer Fehlermeldung (107, 207), wenn eine der basierend auf dem jeweils gemessenen Strom und der jeweils gemessenen Spannung erstellten Spannungs-Strom-Kennlinien von der entsprechenden Soll-Spannungs-Strom-Kennlinie (106, 206) um mehr als einen vorgegebenen Schwellwert abweicht.

2. Verfahren nach Anspruch 1, aufweisend das Erfassen der Soll-Spannungs-Strom-Kennlinien (106, 206) anhand eines vorgegebenen Kabelsatzes (150, 250).

3. Verfahren nach einem der vorherigen Ansprüche, aufweisend das sequentielle elektrische Verbinden der Netzwerke (157, 158, 159, 160) mit einer Signalquelle (101, 201) des Wechselspannungssignals (102, 202), wobei der Schritt des Messens für das jeweils kontaktierte Netzwerk (157, 158, 159, 160) durchgeführt wird.

4. Verfahren nach einem der vorherigen Ansprüche 1 und 2, aufweisend das gleichzeitige elektrische Verbinden von mindestens zwei der Netzwerke (157, 158, 159, 160) mit einer Signalquelle (101, 201) des Wechselspannungssignals (102, 202), wobei der Schritt des Messens für die jeweils kontaktierten Netzwerke (157, 158, 159, 160) durchgeführt wird.

5. Verfahren nach einem der vorherigen Ansprüche, aufweisend das Erzeugen des Wechselspannungssignals (102, 202) mit einer vorgegebenen Frequenz und Amplitude, wobei das Wechselspannungssignal (102, 202) insbesondere in Abhängigkeit der Eigenschaften des zu vermessenden Netzwerks (157, 158, 159, 160) erzeugt wird.

6. Prüfvorrichtung (100, 200) zur Prüfung eines Kabelsatzes (150, 250) mit einer Anzahl von Netzwerken (157, 158, 159, 160) für ein Bordnetz eines Fahrzeugs, wobei mindestens eines der Netzwerke (157, 158, 159, 160) eine Anzahl elektrischer Baugruppen (161, 162) aufweist, aufweisend:
eine Signalquelle (101, 201), welche ausgebildet ist, ein Wechselspannungssignal (102, 202) zu erzeugen,
eine steuerbare Koppeleinrichtung (103), welche ausgebildet ist, die Netzwerke (157, 158, 159, 160) gesteuert mit der Signalquelle (101, 201) zu koppeln,
eine Messeinrichtung (104, 204), welche ausgebildet ist, den Strom und die Spannung für jedes der mit der Signalquelle (101, 201) gekoppelten Netzwerke (157, 158, 159, 160) zu messen, und
eine Steuereinrichtung (105, 205), welche ausgebildet ist, basierend auf dem jeweils gemessenen Strom und der jeweils gemessenen Spannung entsprechende Spannungs-Strom-Kennlinien der jeweiligen Netzwerke (157, 158, 159, 160) zu erstellen und die erstellten Spannungs-Strom-Kennlinien mit vorgegebenen Soll-Spannungs-Strom-Kennlinien (106, 206) zu vergleichen,
wobei die Steuereinrichtung (105, 205) ferner ausgebildet ist, eine Fehlermeldung (107, 207) auszugeben, wenn eine der erstellten Spannungs-Strom-Kennlinien von der entsprechenden Soll-Spannungs-Strom-Kennlinie (106, 206) um mehr als einen vorgegebenen Schwellwert abweicht.

7. Prüfvorrichtung (100, 200) nach Anspruch 6, wobei die Steuereinrichtung (105, 205) ausgebildet ist, die Soll-Spannungs-Strom-Kennlinien (106, 206) anhand eines vorgegebenen Kabelsatzes (150, 250) zu erfassen.

8. Prüfvorrichtung (100, 200) nach einem der vorherigen Ansprüche 6 und 7, wobei die Steuereinrichtung (105, 205) ausgebildet ist, die steuerbare Koppeleinrichtung (103) derart anzusteuern, dass diese die Netzwerke (157, 158, 159, 160) sequentiell mit der Signalquelle (101, 201) koppelt, wobei die Messeinrichtung (104, 204) ausgebildet ist, für das jeweils kontaktierte Netzwerk (157, 158, 159, 160) den Strom und die Spannung zu messen.

9. Prüfvorrichtung (100, 200) nach einem der vorherigen Ansprüche 6 und 7, wobei die Steuereinrichtung (105, 205) ausgebildet ist, die steuerbare Koppeleinrichtung (103) derart anzusteuern, dass diese mindestens zwei der Netzwerke (157, 158, 159, 160) gleichzeitig mit der Signalquelle (101, 201) koppelt, wobei die Messeinrichtung (104, 204) ausgebildet ist, für die jeweils kontaktierten Netzwerke (157, 158, 159, 160) den Strom und die Spannung zu messen.

10. Prüfvorrichtung (100, 200) nach einem der vorherigen Ansprüche 6 bis 9, wobei die Signalquelle (101, 201) ausgebildet ist, das Wechselspannungssignal (102, 202) mit einer vorgegebenen Frequenz und Amplitude zu erzeugen, wobei die Signalquelle (101, 201) insbesondere ausgebildet ist, das Wechselspannungssignal (102, 202) in Abhängigkeit der Eigenschaften des zu vermessenden Netzwerks (157, 158, 159, 160) zu erzeugen.

11. Prüfvorrichtung (100, 200) nach einem der vorherigen Ansprüche 6 bis 10, wobei die Koppeleinrichtung (103) eine mechanische Verbindungseinheit (210) aufweist, welche ausgebildet ist, alle Stecker (151, 152, 153, 154, 155, 156) des Kabelsatzes (150, 250) elektrisch zu kontaktieren.

12. Prüfvorrichtung (100, 200) nach einem der vorherigen Ansprüche 6 bis 11, wobei die Koppeleinrichtung (103) eine Adaptionseinrichtung (211) aufweist, welche ausgebildet ist, gesteuert einzelne Netzwerke (157, 158, 159, 160) mit der Signalquelle (101, 201) und/oder der Messeinrichtung (104, 204) zu koppeln.

## Claims

1. Process of testing a cable set (150, 250) comprising a plurality of networks (157, 158, 159, 160) for an electrical system of a vehicle, at least one of the networks (157, 158, 159, 160) comprising a plurality of electrical assemblies (161, 162), comprising the steps of:
Application (S1) of an AC voltage signal (102, 202) to the networks (157, 158, 159, 160),
Measurement (S2) of the current and voltage for each of the networks (157, 158, 159, 160) to which the AC voltage signal (102, 202) is applied,
Comparison (S3) of voltage-current characteristics of the respective networks (157, 158, 159, 160) generated on the basis of the respective measured current and the respective measured voltage with a predetermined nominal voltage-current characteristic curve(106, 206) for the respective network (157, 158, 159, 160), and
Output (S4) of an error message (107, 207) if one of the voltage-current characteristics generated on the basis of the respectively measured current and the respectively measured voltage deviates from the corresponding target voltage-current characteristic curve (106, 206) by more than a predetermined threshold value.

2. Process according to claim 1, comprising detecting the nominal voltage-current characteristics curve(106, 206) using a predetermined cable set (150, 250).

3. Process according to any one of the preceding claims, comprising sequentially electrically connecting the networks (157, 158, 159, 160) to a signal source (101, 201) of the AC signal (102, 202), wherein the step of measuring is performed for the respectively contacted network (157, 158, 159, 160).

4. Process according to any of the previous claims 1 and 2, comprising electrically connecting at least two of the networks (157, 158, 159, 160) to a signal source (101, 201) of the AC signal (102, 202) simultaneously, wherein the step of measuring is performed for the respectively contacted networks (157, 158, 159, 160).

5. Process according to one of the preceding claims, comprising generating the AC voltage signal (102, 202) with a predetermined frequency and amplitude, wherein the AC voltage signal (102, 202) is generated in particular as a function of the characteristics of the network (157, 158, 159, 160) to be measured.

6. Test device (100, 200) for testing a cable set (150, 250) with a number of networks (157, 158, 159, 160) for a electrical system of a vehicle, wherein at least one of the networks (157, 158, 159, 160) comprises a number of electrical assemblies (161, 162), comprising:
a signal source (101, 201) which is designed to generate an AC voltage signal (102, 202),
a controllable coupling device (103) which is designed to couple the networks (157, 158, 159, 160) to the signal source (101, 201) in a controlled manner,
a measuring device (104, 204) which is designed to measure the current and the voltage for each of the networks (157, 158, 159, 160) coupled to the signal source (101, 201), and
a control device (105, 205) which is designed to generate corresponding voltage-current characteristics curve of the respective networks (157, 158, 159, 160) based on the respectively measured current and the respectively measured voltage and to compare the generated voltage-current characteristics curve with predetermined nominal voltage-current characteristics curve (106, 206),
wherein the control device (105, 205) is further designed to output an error message (107, 207) if one of the generated voltage-current characteristics curve deviates from the corresponding target voltage-current characteristic curve (106, 206) by more than a predetermined threshold value.

7. Test device (100, 200) according to claim 6, wherein the control device (105, 205) is designed to detect the nominal voltage-current characteristics curve (106, 206) by means of a predetermined cable set (150, 250).

8. Test device (100, 200) according to one of the previous claims 6 and 7, wherein the control device (105, 205) is designed to control the controllable coupling device (103) in such a way that it couples the networks (157, 158, 159, 160) sequentially to the signal source (101, 201), wherein the measuring device (104, 204) is designed to measure the current and the voltage for the respectively contacted network (157, 158, 159, 160).

9. Test device (100, 200) according to one of the previous claims 6 and 7, wherein the control device (105, 205) is designed to control the controllable coupling device (103) in such a way that it couples at least two of the networks (157, 158, 159, 160) simultaneously to the signal source (101, 201), wherein the measuring device (104, 204) is designed to measure the current and the voltage for the respectively contacted networks (157, 158, 159, 160).

10. Test device (100, 200) according to one of the previous claims 6 to 9, wherein the signal source (101, 201) is designed to generate the AC voltage signal (102, 202) with a predetermined frequency and amplitude, wherein the signal source (101, 201) is designed in particular to generate the AC voltage signal (102, 202) as a function of the properties of the network (157, 158, 159, 160) to be measured.

11. Test device (100, 200) according to any one of the preceding claims 6 to 10, wherein the coupling device (103) comprises a mechanical connection unit (210) which is configured to electrically contact all connectors (151, 152, 153, 154, 155, 156) of the cable set (150, 250).

12. Test device (100, 200) according to one of the previous claims 6 to 11, wherein the coupling device (103) has an adaptation device (211) which is designed to couple individual networks (157, 158, 159, 160) to the signal source (101, 201) and/or the measuring device (104, 204) in a controlled manner.

## Revendications

1. Procédé de test d'un faisceau de câbles (150, 250) comprenant une pluralité de réseaux (157, 158, 159, 160) pour un réseau de bord d'un véhicule, au moins l'un des réseaux (157, 158, 159, 160) comprenant une pluralité de modules électriques (161, 162), comprenant les étapes consistant à :
l'application (S1) d'un signal de tension alternative (102, 202) aux réseaux (157, 158, 159, 160),
mesurer (S2) le courant et la tension pour chacun des réseaux (157, 158, 159, 160) auxquels le signal de tension alternative (102, 202) est appliqué,
comparer (S3) des caractéristiques tension-courant des réseaux respectifs (157, 158, 159, 160) établies sur la base du courant et de la tension respectivement mesurés à une caractéristique tension-courant de consigne prédéterminée (106, 206) pour le réseau respectif (157, 158, 159, 160), et
l'émission (S4) d'un message d'erreur (107, 207) si l'une des courbes caractéristiques tension-courant établies sur la base du courant et de la tension respectivement mesurés s'écarte de la courbe caractéristique tension-courant de consigne correspondante (106, 206) de plus d'une valeur de seuil prédéterminée.

2. Procédé selon la revendication 1, comprenant la détection des caractéristiques tension-courant de consigne (106, 206) à l'aide d'un jeu de câbles prédéterminé (150, 250).

3. Procédé selon l'une quelconque des revendications précédentes, comprenant la connexion électrique séquentielle des réseaux (157, 158, 159, 160) à une source de signal (101, 201) du signal de tension alternative (102, 202), l'étape de mesure étant effectuée pour le réseau (157, 158, 159, 160) respectivement contacté.

4. Procédé selon l'une des revendications précédentes 1 et 2, comprenant la connexion électrique simultanée d'au moins deux desdits réseaux (157, 158, 159, 160) à une source de signal (101, 201) dudit signal alternatif (102, 202), ladite étape de mesure étant réalisée pour chacun desdits réseaux (157, 158, 159, 160) mis en contact.

5. Procédé selon l'une des revendications précédentes, comprenant la génération du signal alternatif (102, 202) avec une fréquence et une amplitude prédéterminées, le signal alternatif (102, 202) étant généré notamment en fonction des caractéristiques du réseau à mesurer (157, 158, 159, 160).

6. Dispositif de test (100, 200) pour tester un faisceau de câbles (150, 250) comprenant un certain nombre de réseaux (157, 158, 159, 160) pour un réseau de bord d'un véhicule, au moins l'un des réseaux (157, 158, 159, 160) comprenant un certain nombre de modules électriques (161, 162), comprenant :
une source de signal (101, 201) qui est conçue pour générer un signal de tension alternative (102, 202),
un dispositif de couplage (103) pouvant être commandé, qui est conçu pour coupler de manière commandée les réseaux (157, 158, 159, 160) à la source de signaux (101, 201),
un dispositif de mesure (104, 204) qui est conçu pour mesurer le courant et la tension pour chacun des réseaux (157, 158, 159, 160) couplés à la source de signaux (101, 201), et
un dispositif de commande (105, 205) qui est conçu pour établir, sur la base du courant respectivement mesuré et de la tension respectivement mesurée, des courbes caractéristiques tension-courant correspondantes des réseaux respectifs (157, 158, 159, 160) et pour comparer les courbes caractéristiques tension-courant établies avec des courbes caractéristiques tension-courant de consigne (106, 206) prédéfinies,
le dispositif de commande (105, 205) étant en outre conçu pour émettre un message d'erreur (107, 207) si l'une des courbes caractéristiques tension-courant établies s'écarte de la courbe caractéristique tension-courant de consigne (106, 206) correspondante de plus d'une valeur de seuil prédéterminée.

7. Dispositif de test (100, 200) selon la revendication 6, dans lequel le dispositif de commande (105, 205) est conçu pour détecter les caractéristiques tension-courant de consigne (106, 206) à l'aide d'un jeu de câbles (150, 250) prédéfini.

8. Dispositif de test (100, 200) selon l'une des revendications précédentes 6 et 7, dans lequel le dispositif de commande (105, 205) est conçu pour commander le dispositif de couplage commandable (103) de telle sorte que celui-ci couple séquentiellement les réseaux (157, 158, 159, 160) avec la source de signaux (101, 201), le dispositif de mesure (104, 204) étant conçu pour mesurer le courant et la tension pour le réseau (157, 158, 159, 160) respectivement mis en contact.

9. Dispositif de test (100, 200) selon l'une des revendications précédentes 6 et 7, dans lequel le dispositif de commande (105, 205) est conçu pour commander le dispositif de couplage commandable (103) de telle sorte que celui-ci couple simultanément au moins deux des réseaux (157, 158, 159, 160) avec la source de signaux (101, 201), le dispositif de mesure (104, 204) étant conçu pour mesurer le courant et la tension pour les réseaux (157, 158, 159, 160) respectivement mis en contact.

10. Dispositif de contrôle (100, 200) selon l'une des revendications précédentes 6 à 9, dans lequel la source de signal (101, 201) est conçue pour générer le signal de tension alternative (102, 202) avec une fréquence et une amplitude prédéterminées, la source de signal (101, 201) étant notamment conçue pour générer le signal de tension alternative (102, 202) en fonction des caractéristiques du réseau à mesurer (157, 158, 159, 160).

11. Dispositif de test (100, 200) selon l'une des revendications précédentes 6 à 10, dans lequel le dispositif de couplage (103) comprend une unité de connexion mécanique (210) adaptée pour contacter électriquement tous les connecteurs (151, 152, 153, 154, 155, 156) du faisceau de câbles (150, 250).

12. Dispositif de test (100, 200) selon l'une des revendications précédentes 6 à 11, dans lequel le dispositif de couplage (103) comprend un dispositif d'adaptation (211) qui est conçu pour coupler de manière commandée des réseaux individuels (157, 158, 159, 160) à la source de signaux (101, 201) et/ou au dispositif de mesure (104, 204).
